# EUROPEAN PATENT APPLICATION

(11) **EP 2 230 700 A2**
(43) Date of publication of application: **22.09.2010**
(21) Application number: 10156859.0
(22) Date of filing: 18.03.2010
(51) Int. Cl.: H01L 33/50, H01L 33/52

(54) **Light emitting diode package structure and manufacturing method thereof**

(30) Priority: 20.03.2009 TW 98109175
(71) Applicant: Everlight Electronics Co. Ltd., Taipei (TW)
(72) Inventor: Chao, Tzu-Hao, Taipei (TW)
(74) Representative: Becker Kurig Straus

(57) **Abstract**

A method of fabricating a light emitting diode (LED) package structure is provided. A carrier and at least one LED chip having a light emitting surface and a plurality of side surfaces are provided. A first mask having at least one first opening is provided, and the first opening at least exposes the LED chip. A spray coating apparatus is provided above the first mask to perform a first spray coating process. The spray coating apparatus moves back and forth to spray a first phosphor solution over the LED chip so that the light-emitting surface and the side surfaces of the LED chip can be conformally covered by the sprayed first phosphor solution. The first phosphor solution is cured to form a first fluorescent layer by performing a curing process. A molding compound is formed to encapsulate the first fluorescent layer and a portion of the carrier.

## Description

### BACKGROUND OF THE INVENTION

### Field of Invention

The present invention relates to a semiconductor package structure and a manufacturing method thereof, and more generally to a light emitting diode (LED) package structure and a manufacturing method thereof.

### Description of Related Art

Since a light emitting diode (LED) has such advantages as long service life, small volume, high shock resistance, low heat output and low power consumption, it has been widely applied in indicators or light sources for household appliances and various equipment. In recent years, the LED has been developed towards multicolor and high brightness; therefore, its application scope has been expanded to large outdoor display boards, traffic signal lights and the like. In the future, the LED chip may even become the main illumination light source with both power-saving and environment-protecting functions.

A conventional LED package structure is fabricated by a mass production, in which a dispensing process is performed to fill a molding compound into a cave of the chip, and a baking process is then performed to cure the molding compound to complete the LED package structure. However, the molding compound has a fluorescent material therein, and during the step of waiting for the baking process, the fluorescent material is deposited due to the slow filling of the molding compound into the cave of the chip or different timing of filling the molding compound. Accordingly, the distribution of the fluorescent material is not uniform. That is, most portion of the fluorescent material is deposited on the bottom of the cave or the surface of the chip, and only a small portion of the same is distributed in the molding compound sporadically, so as to affect the uniformity of the light emitted from the LED package structure.

Further, the carriers of the conventional LED package structures have various shapes. When a coating process is performed to form a fluorescent layer on the LED chip, the equipment has to be adjusted for different carriers. Therefore, the production efficiency is reduced and the fabrication cost is enhanced.

### SUMMARY OF THE INVENTION

The present invention provides a LED package structure and a method of fabricating the same, so as to enhance the light-emitting uniformity of the LED package structure.

The present invention provides a method of fabricating a LED package structure. First, at least one LED chip is provided. The LED chip is disposed on a carrier and has a light emitting surface and a plurality of side surfaces connected to the light emitting surface. Thereafter, a first mask is provided. The first mask has at least one first opening, and the first opening at least exposes the LED chip. Afterwards, a spray coating apparatus is provided. The spray coating apparatus is disposed above the first mask to perform a first spray coating process. The spray coating apparatus moves back and forth to spray a first phosphor solution over the LED chip so that the light-emitting surface and the side surfaces of the LED chip can be conformally covered by the sprayed first phosphor solution. A curing process is then performed, so as to cure the first phosphor solution on the light emitting surface and the side surfaces of the LED chip to form a first fluorescent layer. Further, a molding compound is formed to encapsulate the first fluorescent layer and a portion of the carrier.

According to an embodiment of the present invention, the first phosphor solution includes a solvent, a gel and a fluorescent powder.

According to an embodiment of the present invention, during the step of spray-coating the first phosphor solution back and forth along the path, the method further includes performing a first heating process on the LED chip and the carrier to evaporate the solvent in the first phosphor solution on the LED chip.

According to an embodiment of the present invention, wherein before the curing process is performed, the method further includes removing the first mask. Thereafter, a second mask is provided above the LED chip. The second mask has at least one second opening smaller than the first opening, and the second opening correspondingly exposes a portion of the first phosphor solution on the light emitting surface of the LED chip. Afterwards, a second spray coating process is performed. The spray coating apparatus moves back and forth to spray a second phosphor solution on the portion of the first phosphor solution exposed by the second opening.

According to an embodiment of the present invention, the second phosphor solution includes a solvent, a gel and fluorescent powder.

According to an embodiment of the present invention, the solvent includes xylene, n-heptane or acetone.

According to an embodiment of the present invention, the gel includes silicone or silica gel or epoxy resin.

According to an embodiment of the present invention, the solvent, the gel and the fluorescent powder respectively account for about 50%, 20% and 30% in the first phosphor solution.

According to an embodiment of the present invention, wherein during the second spray coating process is performed, the method further includes performing a second heating process to evaporate the solvent in the second phosphor solution on the LED chip.

According to an embodiment of the present invention, the spray coating apparatus includes a spray nozzle, and the spray nozzle sprays the first phosphor solution and the second phosphor solution on the LED chip respectively by atomization.

According to an embodiment of the present invention, during the curing process is performed, the method further includes curing the second phosphor solution on the LED chip to form a second fluorescent layer.

According to an embodiment of the present invention, wherein before the first mask is provided, the method further comprises forming at least one wire, and the LED chip is electrically connected to the carrier through the wire.

According to an embodiment of the present invention, the carrier includes a circuit board or a lead frame.

The present invention further provides a LED package structure including a LED chip, a first fluorescent layer, a second fluorescent layer and a molding compound. The LED chip is disposed on a carrier and has a light emitting surface and a plurality of side surfaces connected to the light emitting surface. The first fluorescent layer conformally covers the light emitting surface and the side surfaces of the LED chip. The second fluorescent layer is disposed on a portion of the first fluorescent layer on the light emitting layer of the LED chip. The lens is disposed on the first fluorescent layer, the second fluorescent layer and a portion of the carrier.

According to an embodiment of the present invention, the first fluorescent layer includes a gel and a fluorescent powder.

According to an embodiment of the present invention, the gel includes silicone or silica gel or epoxy resin.

According to an embodiment of the present invention, the second fluorescent layer includes a gel and a fluorescent powder.

According to an embodiment of the present invention, the second fluorescent layer has substantially the same thickness on the first fluorescent layer.

According to an embodiment of the present invention, the thickness of the second fluorescent layer is smaller than, equal than or greater than that of the first fluorescent layer.

According to an embodiment of the present invention, the thickness of the first fluorescent layer is between about 10 µm and 30 µm, and the thickness of the second fluorescent layer is between about 10 µm and 20 µm.

According to an embodiment of the present invention, the LED package structure further includes at least one wire, and the LED chip is electrically connected to the carrier through the wire.

According to an embodiment of the present invention, the carrier includes a circuit board or a lead frame.

In view of above, in the present invention, the phosphor solution is sprayed on the light emitting surface and the side surfaces of the LED chip, and the fluorescent layer has substantially the same thickness on the light emitting surface and the side surfaces of the LED chip. That is, the fluorescent layer is disposed on the emitting surface and the side surfaces of the LED chip with a uniform thickness, and the thickness of the fluorescent layer on the light emitting layer is substantially the same as that on each side surface. Therefore, when the light emitted from the LED chip is transmitted to the external environment through the molding compound, the LED package structure has better light emitting uniformity.

In order to make the aforementioned and other objects, features and advantages of the present invention comprehensible, a preferred embodiment accompanied with figures is described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG 1 schematically illustrates a cross-sectional view of a LED package structure according to an embodiment of the present invention.

FIG. 2 illustrates a flow chart of a method of fabricating a LED package structure according to an embodiment of the present invention.

FIGs. 3A to 3C schematically illustrate cross-sectional views of a method of fabricating a LED package structure according to an embodiment of the present invention.

### DESCRIPTION OF EMBODIMENTS

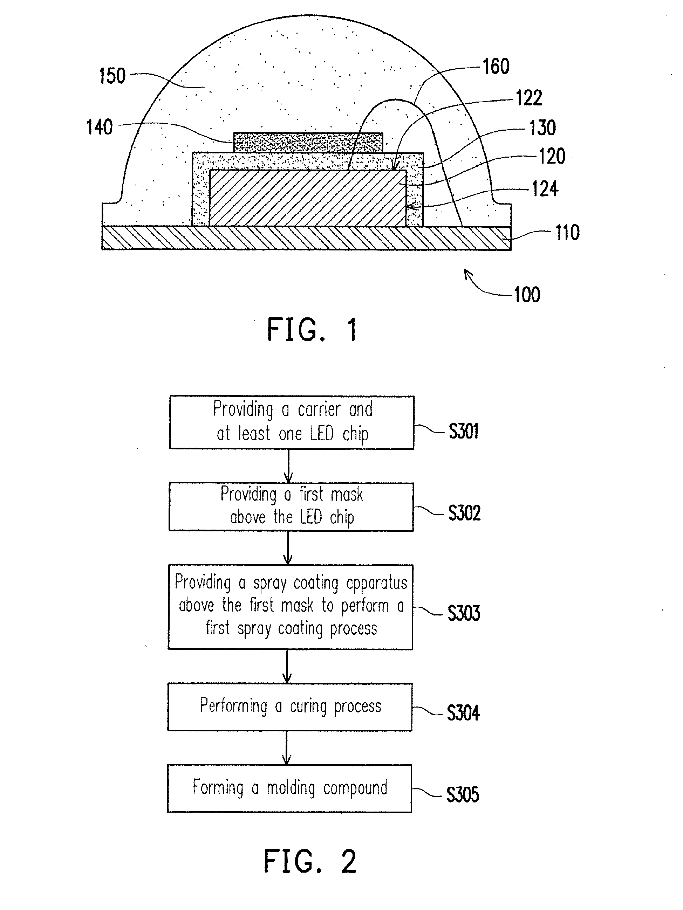

FIG. 1 schematically illustrates a cross-sectional view of a LED package structure according to an embodiment of the present invention. Referring to FIG. 1, the LED package structure 100 includes a carrier 110, a LED chip 120, a first fluorescent layer 130, a second fluorescent layer 140 and a lens, for example a molding compound 150.

In details, the LED chip 120 is disposed on the carrier 110. The LED chip 120 has a light emitting surface 122 and a plurality of side surfaces 124 connected to the light emitting surface 122. The LED chip 120 is electrically connected to the carrier 110 through at least one wire 160 (FIG. 1 only schematically illustrates one wire for illustration purposes). In this embodiment, the carrier 110 is a circuit board or a lead frame, for example. The LED chip 120 includes a blue LED chip, a red LED chip, a green LED chip or a purple LED chip, for example.

The first fluorescent layer 130 is disposed on the LED chip 120 and conformally covers the light emitting surface 122 and the side surfaces 124 of the LED chip 120. The first fluorescent layer 130 has substantially the same thickness on the light emitting surface 122 and the side surfaces 124. That is, the first fluorescent layer 130 is disposed on the light emitting surface 122 and the side surfaces 124 of the LED chip 120 with a uniform thickness, and the thickness of the first fluorescent layer 130 on the light emitting surface 122 is substantially the same as that on each side surface 124. In this embodiment, the first fluorescent layer 130 includes a gel and a fluorescent powder.

The second fluorescent layer 140 is disposed on a portion of the first fluorescent layer 130 on the light emitting surface 122 of the LED chip 120. The second fluorescent layer 140 has substantially the same thickness on the first fluorescent layer 130. That is, the second fluorescent layer 140 is disposed on the portion of the first fluorescent layer 130 on the light emitting surface 122 of the LED chip 120 with a uniform thickness. Further, in this embodiment, the thickness of the second fluorescent layer 140 can be greater than, smaller than or equal to that of the first fluorescent layer 130. Preferably, the thickness of the first fluorescent layer 130 is between about 10 µm and 30 µm, and thickness of the second fluorescent layer 140 is between 10 µm and 20 µm. In this embodiment, the second fluorescent layer 140 includes a gel and a fluorescent powder. It is noted that the fluorescent powder of the first fluorescent layer 130 is substantially the same as that of the second fluorescent layer 140, but the present invention is not limited thereto. It is appreciated by persons skilled in the art that the first fluorescent layer 130 and the second fluorescent layer 140 can have different fluorescent powders upon request.

The molding compound 150 encapsulates the first fluorescent layer 130, the second fluorescent layer 140, the wire 160 and a portion of the carrier 110. The molding compound is for protecting the LED chip 120 and the wire 160 from being affected by the temperature, humidity and signals in the external environment. In this embodiment, the molding compound includes silicone or silica gel or epoxy resin, for example.

The color light emitted from the light emitting surface 122 or the side surfaces 124 of the LED chip 120 is transmitted to the external environment through the molding compound 150. During the process, a portion of the color light emitted from the LED chip 120 irradiates the first fluorescent layer 130 and the second fluorescent layer 140 from the light emitting surface 122, and another portion of the same irradiates the first fluorescent layer 130 from the side surfaces 124. The color light emitted from the LED chip 120 respectively excites the fluorescent powders in the first fluorescent layer 130 and the second fluorescent layer 140 to emit another color light, which is mixed with the color light emitted from the LED chip 120 itself to form white light as seen by human eyes.

In this embodiment, the first fluorescent layer 130 is disposed on the light emitting surface 122 and the side surfaces 124 of the LED chip 120 with a uniform thickness, and the second fluorescent layer 140 is disposed on a portion of the first fluorescent layer 130 on the light emitting surface 122 of the LED chip 120 with a uniform thickness. Therefore, the mixed color light of the color light emitted from the first fluorescent layer 130 and the second fluorescent layer 140 and the color light emitted from the LED chip 120 itself has a better uniformity. That is, when the mixed color light is transmitted to the external environment through the light-transmissive molding compound 150, the uniformity of the light emitted from the LED package structure 100 over all angles is better. In other words, the LED package structure 100 of the present invention has better light emitting uniformity.

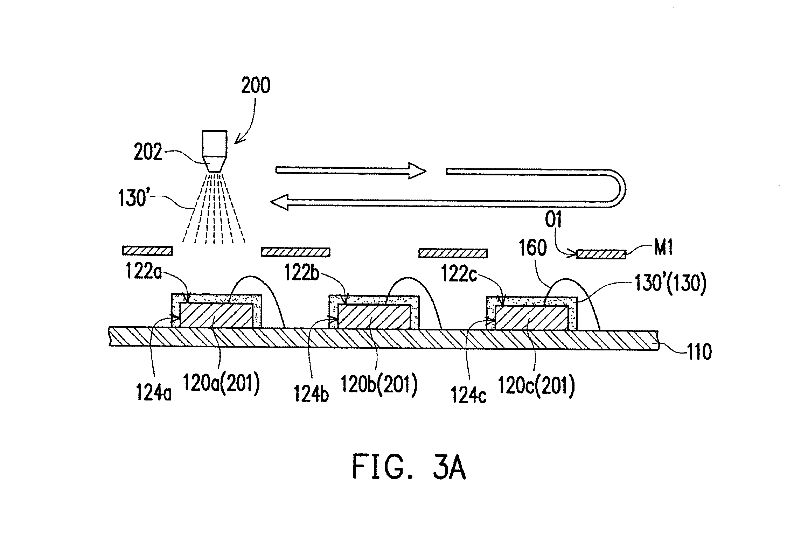

In addition to the above-mentioned LED package structure 100, the present invention also provides a method of fabricating a LED package structure. In the following, the manufacturing method is depicted with accompanying diagrams of FIGs. 2 and 3A-3C, wherein the LED package structure 100 in FIG. 1 is taken as an example.

FIG. 2 illustrates a flow chart of a method of fabricating a LED package structure according to an embodiment of the present invention. FIGs. 3A to 3C schematically illustrate cross-sectional views of a method of fabricating a LED package structure according to an embodiment of the present invention. Referring to FIGs. 2 and 3A, in the step S301, a carrier 110 and a LED chip array 201 are provided. The LED chip array 201 includes a first LED chip 120a, a second LED chip 120b and a third LED chip 120c. Three LED chips in FIG. 3A are provided for illustration purposes, and are not construed as limiting the present invention.

In details, the LED chips 120a, 120b and 120c are disposed on a carrier 110. Each of the LED chips 120a,120b and 120c respectively has a light emitting surface 122a, 122b and 122c and a plurality of side surfaces 124a, 124b and 124c connected to the emitting surface 122a,122b and 122c. Each of the LED chips 120a, 120b and 120c is electronically connected to the carrier 110 through at least one wire 160 (FIG 3A only schematically illustrates one wire for illustration purposes). In this embodiment, the carrier 110 includes a circuit board or a lead frame (not shown), for example. Each LED chip 120a, 120b and 120c of the LED chip array 201 includes a blue LED chip, a red LED chip, a green LED chip or a purple LED chip, for example.

Thereafter, in the step S302, a first mask M1 is provided above the LED chip array 201. In details, the first mask M1 has at least one first opening 01 (FIG. 3A only schematically illustrates three first openings for illustration purposes), and these first openings O1 respectively exposes the corresponding light emitting surfaces 122a, 122b and 122c of the LED chips 120a, 120b and 120c and a portion of the carrier 110.

Afterwards, in the step S303, a spray coating apparatus 200 is provided above the first mask M1 to perform a first spray coating process. The spray coating apparatus 200 moves back and forth (the arrow direction in FIG 3A) to spray a first phosphor solution 130' over the LED chips 120a, 120b and 120c so that the light-emitting surface 122a, 122b and 122c and the side surfaces 124a, 124b and 124c of the LED chips 120a, 120b and 120c can be conformally covered by the sprayed first phosphor solution 130'. In the present invention, the first phosphor solution 130' is spray-coated, back and forth along the same path, on the light emitting surfaces 122a, 122b and 122c and the side surfaces 124a, 124b and 124c of the LED chip 120a, 120b and 120c. Therefore, the distribution of the fluorescent powder is substantially the same on the light emitting surface 122a and the side surfaces 124a of the LED chip 120a as well as on the light emitting surface 122c and the side surfaces 124c of the LED chip 120c. Accordingly, the light emitting uniformity of each of the LED chip 120a, 120b and 120c is enhanced.

In details, the spray coating apparatus 200 includes a two-fluid spray nozzle 202. The two-fluid spray nozzle 202 utilizes the theory that compressed air flows in a high speed to atomize the fluid. The spray coating apparatus 200 spray-coats the first phosphor solution 130' on the light emitting surfaces 122a, 122b and 122c and the side surfaces 124a, 124b and 124c of the LED chip 120a, 120b and 120c through atomization of the two-fluid spray nozzle 202. In this embodiment, the first phosphor solution 130' includes a solvent, a gel and a fluorescent powder, for example. The solvent includes xylene, n-heptane or acetone, for example. The solvent, the gel and the fluorescent powder respectively accounts for about 50%, 20% and 30% in the phosphor solution 130'.

In this embodiment, it is noted that while the first phosphor solution 130' is sprayed on the light emitting surfaces 122a, 122b and 122c and the side surfaces 124a, 124b and 124c of the LED chip 120a, 120b and 120c, a first heating process is performed to evaporate the solvent in the first phosphor solution 130'. The first phosphor solution 130' of the present invention has the solvent, and the solvent helps to reduce the viscosity of the first phosphor solution 130', so that when the two-fluid spray nozzle 202 is adopted to spray-coat the first phosphor solution 130', the first phosphor solution 130' can distribute uniformly on the light emitting surfaces 122a, 122b and 122c and the side surfaces 124a, 124b and 124c of the LED chip 120a, 120b and 120c. Meanwhile, the first heating process is performed to solidify the first phosphor solution 130'. Therefore, a non-uniform distribution of the fluorescent powder in the first phosphor solution 130' is not observed. That is, after the first heating process, only the fluorescent powder in the first phosphor solution 130' and few gel remain on the light emitting surfaces 122a, 122b and 122c and the side surfaces 124a, 124b and 124c of the LED chip 120a, 120b and 120c.

The first mask M1 is then removed.

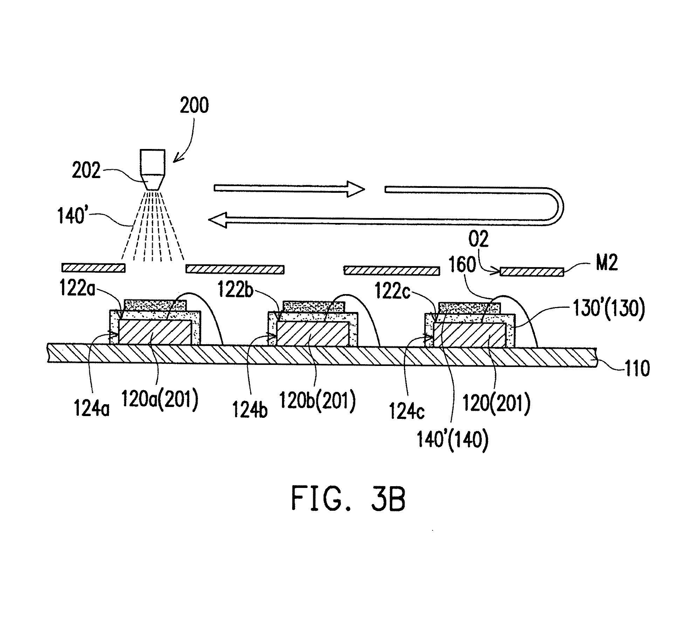

Referring to FIG 3B, a second mask M2 is provided above the LED chip 120a, 120b and 120c. The second mask M2 is disposed between each of the LED chips 120a, 120b and 120c and the spray coating apparatus 200. The second mask M2 has at least one second opening 02 (FIG. 3B only schematically illustrate three second openings for illustration purposes), and these second openings 02 exposes a portion of the first phosphor solution 130' on the corresponding light emitting surfaces 122a, 122b and 122c of the LED chip 120a, 120b and 120c.

Thereafter, referring to FIG 3B, a second spray-coating process is performed. The spray coating apparatus 200 moves back and forth (the arrow direction in FIG. 3B) to spray a second phosphor solution 140' on the portion of the first phosphor solution 130' on the light emitting surfaces 122a, 122b and 122c of the LED chip 120a, 120b and 120c exposed by the second openings 02. In this embodiment, the second phosphor solution 140' is spray-coated on the portion of the first phosphor solution 130' on the light emitting surfaces 122a, 122b and 122c of the LED chip 120a, 120b and 120c through atomization of the two-fluid spray nozzle 202. The second phosphor solution 140' includes a solvent, a gel and a fluorescent powder, for example. The solvent includes xylene, n-heptane or acetone, for example. The solvent, the gel and the fluorescent powder respectively accounts for about 50%, 20% and 30% in the second phosphor solution 140'.

In this embodiment, it is noted that while the second phosphor solution 140' is sprayed on the first phosphor solution 130' on the light emitting surfaces 122a, 122b and 122c of the LED chip 120a, 120b and 120c, a second heating process is performed to evaporate the solvent in the second phosphor solution 140'. The second phosphor solution 140' of the present invention has the solvent, and the solvent helps to reduce the viscosity of the second phosphor solution 140', so that when the two-fluid spray nozzle 202 is adopted to spray the second phosphor solution 140', the second phosphor solution 140' can distribute uniformly on the first phosphor solution 130' on the light emitting surfaces 122a, 122b and 122c of the LED chip 120a, 120b and 120c. Meanwhile, the second heating process is performed to solidify the second phosphor solution 140'. Therefore, a non-uniform distribution of the fluorescent powder in the second phosphor solution 140' is not observed. That is, after the second heating process, only the fluorescent powder in the second phosphor solution 140' and few gel remain on the first phosphor solution 130' on the light emitting surfaces 122a, 122b and 122c of the LED chip 120a, 120b and 120c.

Further, in this embodiment, the first phosphor solution 130' is substantially the same as the second phosphor solution 140', but the present invention is not limited thereto. It is for sure that the first phosphor solution 130' can be different from the second phosphor solution 140' due the different fluorescent powders used in the phosphor solutions, which still belong to a technical means adoptable in the present invention and falls within the protection scope of the present invention.

Thereafter, in the step S304, a curing process is performed to cure the first phosphor solution 130' to form a first fluorescent layer 130 and to cure the second phosphor solution 140' to form a second fluorescent layer 140. In details, the first fluorescent layer 130 has substantially the same thickness on the light emitting surfaces 122a, 122b and 122c and the side surfaces 124a, 124b and 124c of the LED chips 120a, 120b and 120c. That is, the first fluorescent layer 130 is disposed on the light emitting surfaces 122a, 122b and 122c and the side surfaces 124a, 124b and 124c of the LED chips 120a, 120b and 120c with a uniform thickness. The thickness of the first fluorescent layer 130 on each of the light emitting surfaces 122a, 122b and 122c is the same as that on each of the side surfaces 124a, 124b and 124c. The second fluorescent layer 140 has substantially the same thickness on the portion of the first fluorescent layer 130 on the light emitting surfaces 122a, 122b and 122c of the LED chips 120a, 120b and 120c, and the thickness of the second fluorescent layer 140 is smaller than , equal than or greater than that of the first fluorescent layer 130.

The second mask M2 is then removed.

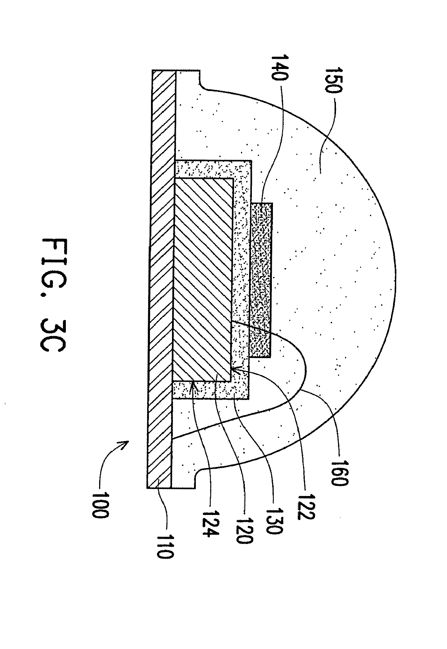

Afterwards, in the step S305, a molding compound 150 is formed to encapsulate the first fluorescent layer 130, the second fluorescent layer 140, the wire 160 and a portion of the carrier 110. The molding compound 150 is for protecting the LED chips 120a, 120b and 120c and each wire 160 from being affected by the temperature, humidity and signals in the external environment. In this embodiment, the molding compound includes light-transmissive epoxy resin or silicone, for example. Further, a singulation process is preformed to form a plurality of independent LED package structure 100, as shown in FIG. 3C.

In short, in the method of the present invention, the first phosphor solution 130' is sprayed on the light emitting surfaces 122a, 122b and 122c and the side surfaces 124a, 124b and 124c of the LED chips 120a, 120b and 120c. Accordingly, the first fluorescent layer 130 is disposed on the light emitting surfaces 122a, 122b and 122c and the side surfaces 124a, 124b and 124c of the LED chips 120a, 120b and 120c with a uniform thickness. The thickness of the first fluorescent layer 130 on each of the light emitting surfaces 122a, 122b and 122c is substantially the same as that on each of the side surfaces 124a, 124b and 124c. Therefore, the light emitting uniformity of each LED package structure 100 is enhanced by the manufacturing method of the present invention.

Further, the color light emitted from each of the LED chips 120a, 120b and 120c is very directional (i.e. stronger light emitted from the light emitting surface). To solve the problem, in the present invention, after the first spray coating process, the second mask M2 which has a different dimension from the first mask M1 is used to perform the second spray coating process, so as to form the second fluorescent layer 140 on the first fluorescent layer 130 of the LED chips 120a, 120b and 120c. In other words, by using the masks with different dimensions, a local multi-phosphor layer structure is formed on each of the LED chips 120a, 120b and 120c, so as to enhance the uniformity of the light emitted from each LED package structure 100.

Moreover, the spray coating apparatus 200 sprays the second phosphor solution 140' back and forth along the same path on the first fluorescent layer 130 on the light emitting surfaces 122a, 122b and 122c of the LED chips 120a, 120b and 120c. Accordingly, the second fluorescent layer 140 is disposed on the first fluorescent layer 130 on the light emitting surfaces 122a, 122b and 122c of the LED chips 120a, 120b and 120c with a uniform thickness. Therefore, when the color light emitted from the first fluorescent layer 130 and the second fluorescent layer140 is mixed with the color light emitted from each of the LED chips 120a, 120b and 120c, and the mixed color light is transmitted to the external environment through the molding compound 150, the uniformity of light emitted from each LED package structure 100 over all angles is better. That is, each LED package structure 100 fabricated by the method of the present invention has better light emitting uniformity.

In summary, the first phosphor solution is sprayed back and forth along the same path on the light emitting surfaces and the side surfaces of the LED chips, and the second phosphor solution is sprayed in the same manner on the first fluorescent layer 130. Accordingly, the first fluorescent layer is disposed on the light emitting surfaces and the side surfaces of the LED chips with a uniform thickness, and the second fluorescent layer is disposed on the first fluorescent layer on the light emitting surfaces with a uniform thickness. Therefore, when the color light emitted from the first fluorescent layer and/or the second fluorescent layer is mixed with the color light emitted from each LED chip itself, and the mixed color light is transmitted to the external environment through the molding compound, the uniformity of the light emitted from each LED package structure over all angles is better. In other words, each LED package structure of the present invention has better light emitting uniformity.

This invention has been disclosed above in the preferred embodiments, but is not limited to those. It is known to persons skilled in the art that some modifications and innovations may be made without departing from the spirit and scope of this invention. Hence, the scope of this invention should be defined by the following claims.

## Claims

1. A method of fabricating a light emitting diode (LED) package structure (100), comprising:
providing at least one LED chip (120, 120a, 120b, 120c) , wherein the LED chip (120, 120a, 120b, 120c)is electronically connected with a carrier (110)and has a light emitting surface (122, 122a, 122b, 122c) and a plurality of side surfaces 124, 124a, 124b, 124c) connected to the light emitting surface (122, 122a, 122b, 122c) ;
providing a first mask (M1), wherein the first mask (M1) has at least one first opening (O1) positioned related to the LED chip (120, 120a, 120b, 120c) ;
providing a spray coating apparatus (200), wherein the spray coating apparatus (200) is disposed above the first mask (M1) to perform a first spray coating process, and the spray coating apparatus (200) moves back and forth to spray a first phosphor solution (130') over the LED chip (120, 120a, 120b, 120c) so that the light-emitting surface (122, 122a, 122b, 122c) and the side surfaces 124, 124a, 124b, 124c) of the LED chip (120, 120a, 120b, 120c) can be conformally covered by the sprayed first phosphor solution (130') ;
performing a curing process to cure the first phosphor solution (130') to form a first fluorescent layer (130) ; and
forming a molding compound (150) to encapsulate the first fluorescent layer (130) and a portion of the carrier (110).

2. The method of fabricating the LED package structure(100) as claimed in claim 1, wherein the first phosphor solution (130') comprises a solvent, a gel and a fluorescent powder.

3. The method of fabricating the LED package structure (100)as claimed in claim 2, during the step of spray-coating the first phosphor solution (130') back and forth along the path, the method further comprises performing a first heating process on the LED chip (120, 120a, 120b, 120c) and the carrier (110) to evaporate the solvent in the first phosphor solution (130') on the LED chip (120, 120a, 120b, 120c) .

4. The method of fabricating the LED package structure(100) as claimed in claim 1, wherein before the curing process is performed, the method further comprises:
removing the first mask (M1) ;
providing a second mask (M2) above the LED chip (120, 120a, 120b, 120c), wherein the second mask (M2) has at least one second opening (O2) smaller than the first opening (O1) , and the second opening (O2) correspondingly exposes a portion of the first phosphor solution (130') on the light emitting surface (122, 122a, 122b, 122c) of the LED chip (120, 120a, 120b, 120c) ; and
performing a second spray coating process, wherein the spray coating apparatus (200) sprays a second phosphor solution (140') on the portion of the first fluorescent layer (130) exposed by the second opening (O2).

5. The method of fabricating the LED package structure(100) as claimed in claim 4, wherein the second phosphor solution (140') comprises a solvent, a gel and fluorescent powder.

6. The method of fabricating the LED package structure (100) as claimed in claim 2, wherein the solvent comprises xylene, n-heptane or acetone.

7. The method of fabricating the LED package structure (100) as claimed in claim 6, wherein the gel comprises silicone or silica gel or epoxy resin.

8. The method of fabricating the LED package structure (100) as claimed in claim 7, wherein the solvernt, the gel and the fluorescent powder respectively account for about 50%, 20% and 30% in the first phosphor solution (130') .

9. The method of fabricating the LED package structure (100) as claimed in claim 5, during the step of performing the second spray coating process, the method further comprises performing a second heating process to evaporate the solvent in the second phosphor solution (140') on the LED chip (120, 120a, 120b, 120c) .

10. The method of fabricating the LED package structure (100) as claimed in claim 4, wherein the spray coating apparatus comprises a spray nozzle (202), and the spray nozzle (202) sprays the first phosphor solution (130') and the second phosphor solution (140')on the LED chip (120, 120a, 120b, 120c) respectively by atomization.

11. The method of fabricating the LED package structure (100) as claimed in claim 4, wherein during the curing process is performed, the method further comprises curing the second phosphor solution (140') on the LED chip (120, 120a, 120b, 120c) to form a second fluorescent layer (140) .

12. The method of fabricating the LED package structure (100) as claimed in claim 1, wherein before the first mask (M1) is provided, the method further comprises forming at least one wire (160), and the LED chip (120, 120a, 120b, 120c) is electrically connected to the carrier (110) through the wire (160) .

13. The method of fabricating the LED package structure (100) as claimed in claim 1, wherein the carrier (110) comprises a circuit board or a lead frame.

14. A light emitting diode (LED) package structure (100), comprising:
a LED chip (120, 120a, 120b, 120c), disposed on a carrier (110) and having a light emitting surface (122, 122a, 122b, 122c) and a plurality of side surfaces (124, 124a, 124b, 124c) connected to the light emitting surface (122, 122a, 122b, 122c) ;
a first fluorescent layer (130)conformally covering the light emitting surface(122, 122a, 122b, 122c) and the side surfaces(124, 124a, 124b, 124c) of the LED chip(120, 120a, 120b, 120c) ;
a second fluorescent layer (140), disposed on a portion of the first fluorescent layer(130) on the light emitting layer (122, 122a, 122b, 122c) of the LED chip (120, 120a, 120b, 120c) ; and
a lens, disposed on the first fluorescent layer (130), the second fluorescent layer (140) and a portion of the carrier (110) .

15. The LED package structure (100) as claimed in claim 14, wherein the first fluorescent layer (130) comprises a gel and a fluorescent powder.

16. The LED package structure (100) as claimed in claim 15, the gel comprises silicone or silica gel or epoxy resin.

17. The LED package structure (100) as claimed in claim 14, wherein the second fluorescent layer (140) comprises a gel and a fluorescent powder.

18. The LED package structure (100) as claimed in claim 14, wherein the second fluorescent layer (140) has substantially the same thickness on the first fluorescent layer (130) .

19. The LED package structure (100) as claimed in claim 14, wherein a thickness of the second fluorescent layer (140) is smaller than, equal than or greater than a thickness of the first fluorescent layer (130).

20. The LED package structure (100) as claimed in claim 19, wherein the thickness of the first fluorescent layer (130) is between about 10 µm and 30 µm, and the thickness of the second fluorescent layer (140) is between about 10 µm and 20 µm.

21. The LED package structure (100) as claimed in claim 14, further comprising at least one wire (160), wherein the LED chip (120,120a, 120b, 120c) is electrically connected to the carrier (110) through the wire (160) .

22. The LED package structure (100) as claimed in claim 21, wherein the carrier (110) comprises a circuit board or a lead frame.
